(19) Europäisches Patentamt
European Patent Office
Office européen des brevets

(11) **EP 2 850 445 B1**

## (12) FASCICULE DE BREVET EUROPEEN

(45) Date de publication et mention de la délivrance du brevet:
**10.07.2019 Bulletin 2019/28**

(21) Numéro de dépôt: **13727291.0**

(22) Date de dépôt: **15.05.2013**

(51) Int Cl.:
***G01R 31/36*** *(2019.01)*

(86) Numéro de dépôt international:
**PCT/FR2013/051055**

(87) Numéro de publication internationale:
**WO 2013/171425 (21.11.2013 Gazette 2013/47)**

(54) **SYSTÈME ET PROCÉDÉ CORRESPONDANT D'ESTIMATION DE L'ÉTAT DE CHARGE D'UNE BATTERIE**

SYSTEM UND ENTSPRECHENDES VERFAHREN ZUR BESTIMMUNG DES LADEZUSTANDES EINER BATTERIE

SYSTEM AND CORRESPONDING METHOD FOR ESTIMATING THE CHARGE STATUS OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.05.2012 FR 1254426**

(43) Date de publication de la demande:
**25.03.2015 Bulletin 2015/13**

(73) Titulaire: **Renault S.A.S.**
**92100 Boulogne-Billancourt (FR)**

(72) Inventeurs:
- DRIEMEYER-FRANCO, Ana-Lucia
  F-78180 Montigny-Le-Bretonneux (FR)
- LUCEA, Marc
  78000 Versailles (FR)
- SAINT-MARCOUX, Antoine
  F-91120 Palaiseau (FR)
- BUI-VAN, Anh-Linh
  F-38250 Saint Nizier du Moucherotte (FR)
- PERICHON, Pierre
  F-38500 Voiron (FR)

(56) Documents cités:
**US-A1- 2004 135 545     US-A1- 2007 262 750
US-A1- 2010 085 009**

- **BRANDL M ET AL: "Batteries and battery management systems for electric vehicles", DESIGN, AUTOMATION&TEST IN EUROPE CONFERENCE&EXHIBITION (DATE), 2012, IEEE, 12 mars 2012 (2012-03-12), pages 971-976, XP032320886, DOI: 10.1109/DATE.2012.6176637 ISBN: 978-1-4577-2145-8**

**Description**

L'invention concerne principalement les systèmes de mesure et d'estimation de l'état de charge d'une batterie, notamment d'une batterie d'un véhicule automobile, par exemple à propulsion électrique.

Il est connu de l'état de la technique de déterminer l'état de charge d'une batterie aux moyens de capteurs de courant dont l'intensité mesurée est intégrée pour déterminer la charge restante pour chaque cellule. Cette méthode de mesure manque de précision notamment en raison de la dérive et du biais de la mesure après de longues périodes de mesure. D'autre part, il se pose également la question de l'initialisation de l'intégration et de la précision du capteur.

Il est connu de l'état de la technique, de déterminer l'état de charge d'une batterie au moyen de capteurs de tension qui mesurent la tension aux bornes d'une cellule de la batterie. En effet, lorsque la cellule ne débite pas de courant, cette mesure de tension permet d'estimer une tension à vide de laquelle on peut déterminer l'état de charge. Cette méthode est perturbée lorsque la batterie est traversée par un courant.

Il est également connu de l'état de la technique, de déterminer l'état de charge d'une batterie à l'aide de mesures de courant et de tension. Dans ce cas, l'estimation par intégration est corrigée par les mesures de tension lorsque la batterie ne débite pas de courant, lors d'un arrêt du véhicule par exemple.

Il est également possible d'estimer l'état de charge à l'aide de modèles de comportement de la cellule par des outils d'estimation dédiés comme le filtrage de Kalman, par exemple. Ces méthodes présentent l'inconvénient d'être complexes et d'avoir un coût important.

Il est connu de la demande de brevet EP1384086 la détermination d'un état de charge à partir d'une tension à vide mesurée ou prédite. Un inconvénient de cette solution est qu'elle nécessite d'interrompre l'utilisation de la batterie, durant la décharge ou durant la charge, afin de mesurer la tension à ses bornes en circuit ouvert. L'article "Batteries and Battery Management Systems for Electric Vehicles" (M. Brandl et al.) décrit un système présentant les mêmes inconvénients.

Au vu de ce qui précède, un but de l'invention est de proposer un système et un procédé correspondant d'estimation de l'état de charge d'une batterie qui permette de résoudre au moins en partie les inconvénients mentionnés ci-dessus.

L'invention a donc pour objet un système d'estimation de l'état de charge d'une batterie comportant au moins deux modules équipés chacun d'au moins une cellule, ledit système comprenant un capteur du courant série traversant l'ensemble des cellules des modules connectés en série.

Selon une caractéristique générale, ce système comprend en outre :

-   des moyens de commutation capable de sélectivement déconnecter l'un des modules, les autres modules restant connectés en série; et
-   un moyen de calcul configuré pour calculer l'état de charge des cellules traversées par ledit courant série à partir de l'intégration du courant série et pour calculer l'état de charge de chacune des cellules du module déconnecté à partir de leur tension à vide.

Ainsi, on peut réaliser une détermination de l'état de charge à l'aide de la tension à vide estimée ou mesurée des cellules du module déconnecté. Cette détermination permet de corriger la mesure de l'état de charge à l'aide du capteur de courant pour supprimer des dérives, critiques notamment après de longues périodes de mesure. Selon l'invention, cette détermination peut être effectuée sans interrompre le fonctionnement de la batterie, les autres modules restant connectés en série.

On peut donc réaliser la détermination de l'état de charge à chaque fois qu'un module est déconnecté sans attendre un événement particulier. La déconnexion des modules sera gérée en fonction des besoins des consommateurs sur la batterie, mais il est dans la plupart des cas possible de fonctionner avec au moins un module déconnecté. Un exemple de situation pour laquelle tous les modules devront être reconnectés correspond au cas où la chaîne de traction a besoin de la puissance maximale de la batterie, puisqu'on a alors intérêt à délivrer la tension maximale en sortie batterie. Cependant, cette situation est limitée en fréquence et en durée. On peut ainsi obtenir une correction assez fréquente de l'estimation de l'état de charge obtenue à l'aide du capteur de courant, ce qui induit une estimation de l'état de charge plus précise.

Selon une caractéristique, le système comprend en outre des capteurs de tension aux bornes de chacune des cellules du module déconnecté et le moyen de calcul est configuré pour calculer la tension à vide de chacune des cellules du module déconnecté à partir de la tension aux bornes de la cellule.

Il est ainsi prévu de calculer la tension à vide des cellules du module déconnecté à l'aide de la tension à leurs bornes (mesurée une fois le module déconnecté, sans nécessairement attendre un long délai de relaxation), ce qui permet de réaliser ce calcul plus rapidement.

Selon un premier mode de réalisation, le moyen de calcul comprend des moyens d'estimation configurés pour estimer, pour chacune des cellules du module déconnecté, la tension à vide à partir de la tension aux bornes de la cellule, lesdits moyens d'estimation comprenant :

- des moyens d'enregistrement pour conserver en mémoire la valeur d'un coefficient obtenu par des essais de caractérisation de la cellule; et
- des moyens d'addition configurés pour additionner la tension aux bornes de la cellule au moment de la déconnexion du module avec le résultat de la multiplication entre ledit coefficient et la différence entre la tension aux bornes de la cellule un court instant après la déconnexion du module et la tension aux bornes de la cellule au moment de la déconnexion du module.

Ainsi, on calcule la tension à vide de la cellule très rapidement sans avoir à attendre la relaxation de la cellule à partir de la déconnexion. Cela permet d'une part d'augmenter la disponibilité du module déconnecté et d'autre part d'augmenter la fréquence de correction et donc la précision de la mesure.

Selon un deuxième mode de réalisation, le moyen de calcul comprend des moyens d'estimation configurés pour estimer, pour chacune des cellules du module déconnecté, la tension à vide à partir des tensions aux bornes de la cellule, lesdits moyens d'estimation comprenant :

- des moyens de détermination d'une loi régissant la chute de polarisation de la cellule, à partir de l'évolution de la tension aux bornes de la cellule pendant une certaine durée à compter de la déconnexion du module ; et
- des moyens de calcul de la valeur vers laquelle ladite loi converge.

Il est ainsi prévu également une détermination rapide de la tension à vide. L'utilisation d'une loi de chute de polarisation de la cellule permet de manière supplémentaire de ne pas nécessiter de caractérisation préalable. Ainsi, on obtient une mesure robuste qui peut s'adapter aux changements et notamment à l'usure d'une cellule. Ce deuxième mode de réalisation présente toutefois l'inconvénient de nécessiter un plus long délai de relaxation (de l'ordre de 5 minutes) pour déterminer la loi régissant la chute de polarisation de la cellule. La détermination de cette loi n'est cependant pas nécessaire à chaque commutation d'un module : la mise à jour des paramètres de cette loi d'évolution peut être bien moins fréquente que les déconnexions des modules. Ainsi, on peut prévoir par exemple une mise à jour des paramètres de la loi par mois et plusieurs déconnexions de modules à chaque cycle de charge/décharge du pack batterie.

Selon un autre mode de réalisation, les moyens de commutation sont contrôlés par un moyen de contrôle, les moyens de commutation étant contrôlés par le moyen de contrôle de sorte que chacun des modules est déconnecté régulièrement.

En déconnectant régulièrement chacun des modules, il est possible de corriger régulièrement l'estimation de l'état de charge par intégration du courant série de chacun des modules. On obtient ainsi une estimation plus précise de l'état de charge de la batterie.

Selon encore un autre mode de réalisation, les moyens de commutation comprennent pour chacun des modules de la batterie, un commutateur série branché à l'entrée du module correspondant et des commutateurs parallèle branchés en parallèle de chacun des commutateurs série et du module correspondant.

Les moyens de commutation ne comprennent que deux commutateurs par module et sont simples à contrôler.

Selon une autre caractéristique, au moins un module comprend un moyen d'équilibrage configuré pour ajouter un courant d'équilibrage au courant traversant les cellules dudit module.

Les moyens d'équilibrage peuvent en délivrant un tel courant, équilibrer les états de charges des cellules constituant chacun des modules.

Selon un autre aspect, il est proposé un procédé d'estimation de l'état de charge d'une batterie comportant au moins deux modules équipés chacun d'au moins une cellule.

Selon une caractéristique générale, ce procédé comprend :

- une étape de déconnexion sélective d'un module, les autres modules restant connectés en série et leurs cellules étant traversées par un courant série ;
- des étapes de détermination réalisées successivement comprenant, pour chacune des cellules de la batterie :

  - une intégration du courant série parcourant la cellule, avec pour condition initiale le dernier état de charge déterminé de la cellule, si la cellule appartient à un module connecté en série; ou
  - une étape de détermination de l'état de charge de la cellule à partir de la tension à vide de la cellule, si la cellule appartient à un module déconnecté.

La détermination de l'état de charge à l'aide de la tension à vide estimée ou mesurée d'une cellule d'un module déconnecté permet une détermination plus précise que la mesure par intégration du courant série. Ainsi, on peut corriger la dérive de la mesure par intégration. D'autre part, étant donné que seul un module est déconnecté, les autres modules fonctionnent et peuvent délivrer un courant par exemple au moteur de propulsion électrique du véhicule automobile comportant la batterie.

Selon un mode de mise en oeuvre, l'étape de détermination de l'état de charge à partir de la tension à vide de la cellule, si la cellule appartient à un module déconnecté, comprend :

- une détermination de la durée de déconnexion ;
- une estimation de la tension à vide de la cellule à partir de la mesure de la tension aux bornes de la cellule et une détermination de l'état de charge à partir de ladite tension à vide estimée, si la durée de déconnexion est égale à une certaine durée ; ou
- une recopie du dernier état de charge estimé de la cellule, si la durée de déconnexion est inférieure ou supérieure à ladite certaine durée.

Ainsi, on attend suffisamment de temps après la déconnexion pour pouvoir extrapoler la tension à vide de la cellule à partir de la tension aux bornes de cette cellule. Cette estimation de la tension à vide, obtenue par extrapolation, permet un recalage précis des estimations d'état de charge.

Selon un autre mode de mise en oeuvre, le procédé comprend en outre une étape d'arrêt qui comprend une mémorisation des dernières valeurs d'état de charge déterminées pour chacune des cellules.

D'autres buts, caractéristiques et avantages apparaîtront à la lecture de la description suivante, donnée uniquement à titre d'exemple non limitatif, et faite en référence aux dessins annexés sur lesquels :

- la figure 1 illustre un schéma de principe d'un système d'estimation de la charge d'une batterie selon un mode de réalisation de l'invention;
- la figure 2 illustre l'estimation de la tension à vide d'une cellule ; et
- la figure 3 montre une courbe qui représente la tension à vide d'une cellule en fonction de son état de charge;
- les figures 4 et 5 illustrent un schéma de principe d'un procédé d'estimation de la charge d'une batterie selon un mode de mise en oeuvre de l'invention.

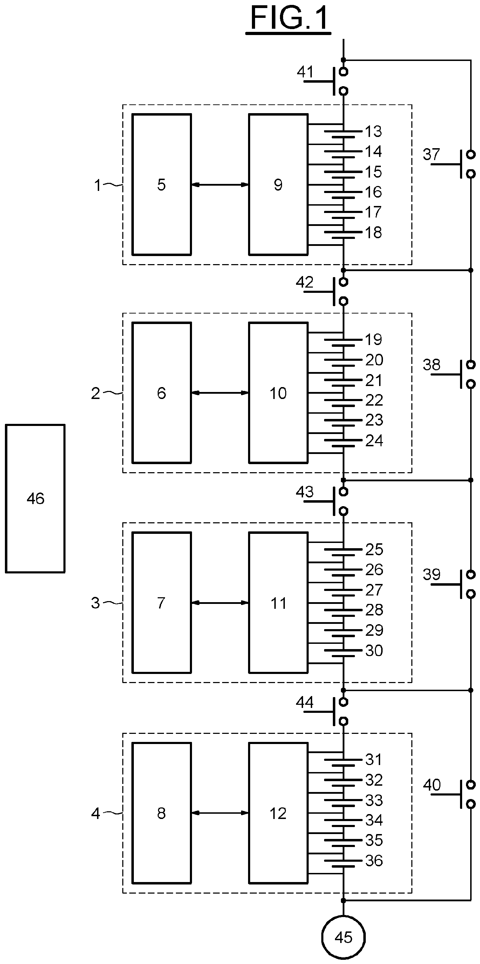

Sur la figure 1 sont illustrés une batterie comprenant 4 modules ou blocs de batterie 1, 2, 3 et 4, des moyens de commutation 37 à 44, un capteur de courant 45 et un bloc de contrôle et de calcul 46.

Chacun des modules 1, 2, 3 et 4 comprend 6 cellules : 13, 14, 15, 16, 17, 18 pour le module 1 ; 19, 20, 21, 22, 23, 24 pour le module 2 ; 25, 26, 27, 28, 29, 30 pour le module 3 ; et 31, 32, 33, 34, 35, 36 pour le module 4.

Chacun des modules 1, 2, 3 et 4 comprend également un circuit intégré de mesure de la tension aux bornes de chacune des cellules de son module : le circuit intégré 9 pour le module 1 et pour mesurer la tension aux bornes des cellules 13, 14, 15, 16, 17, 18 ; le circuit intégré 10 pour le module 2 et pour mesurer la tension aux bornes des cellules 19, 20, 21, 22, 23, 24 ; le circuit intégré 11 pour le module 3 et pour mesurer la tension aux bornes des cellules 25, 26, 27, 28, 29, 30 ; et le circuit intégré 12 pour le module 4 et pour mesurer la tension aux bornes des cellules 31, 32, 33, 34, 35, 36.

De manière optionnelle, au moins un des modules 1, 2, 3 et 4 comprend un bloc d'équilibrage configuré pour ajouter au courant traversant les cellules du module, un courant d'équilibrage. A titre d'exemple de réalisation, le module 1 comprend le bloc d'équilibrage 5, le module 2 comprend le bloc d'équilibrage 6, le module 3 comprend le bloc d'équilibrage 7 et le module 4 comprend le bloc d'équilibrage 8. Chacun de ces blocs d'équilibrage permet de délivrer un courant d'équilibrage traversant une ou plusieurs cellules, de manière à équilibrer les états de charges des cellules composant le module.

Les moyens de commutation comprennent des commutateurs série 41, 42, 43 et 44 branchés respectivement à l'entrée de chacun des modules 1, 2, 3 et 4. Les moyens de commutation comprennent également des commutateurs parallèle 37, 38, 39 et 40 branchés respectivement en parallèle de chacun des couples de module et commutateur d'entrée (1, 41), (2,42), (3, 43) et (4, 44).

Le bloc de contrôle et de calcul 46 contrôle les moyens de commutation de sorte qu'un des modules 1, 2, 3 ou 4 soit déconnecté et qu'un courant série traverse les modules restants. Il contrôle également les blocs d'équilibrage, en pilotant les éventuels courant d'équilibrage traversant une ou plusieurs cellules du module. Avantageusement, le bloc 46 contrôle les moyens de commutation de sorte que chacun des modules 1, 2, 3 et 4 soit déconnecté régulièrement.

Par exemple, dans le cas de la déconnexion du module 2, d'une part le commutateur série 42 du module 2 est ouvert (OFF selon un terme anglo-saxon bien connu de l'homme du métier) et le commutateur parallèle 38 du module 2 est fermé (ON selon un terme anglo-saxon bien connu de l'homme du métier) et d'autre part les commutateurs parallèle 37, 39 et 40 des modules restants sont ouverts (OFF) et les commutateurs série 41, 43, 44 des modules restants sont fermés (ON).

Il apparaît donc que la connexion de chacun des modules est réalisée en ouvrant (OFF) son commutateur parallèle et en fermant (ON) son commutateur série. La déconnexion de chacun des modules est réalisée en ouvrant (OFF) son commutateur série et en fermant (ON) son commutateur parallèle.

Le bloc de contrôle et de calcul 46, contrôle les circuits intégrés de mesure de sorte que la tension aux bornes de chacune des cellules du module déconnecté soit mesurée.

Puis le bloc 46 recueille les mesures de tension aux bornes de chacune des cellules du module déconnecté. Il peut alors en déduire la tension à vide (OCV, Open Circuit Voltage selon un terme anglo-saxon bien connu de l'homme du métier) de chacune des cellules du module déconnecté. Cela étant, la tension à vide de chacune de ces cellules n'est pas toujours égale à la tension aux bornes de chacune des cellules.

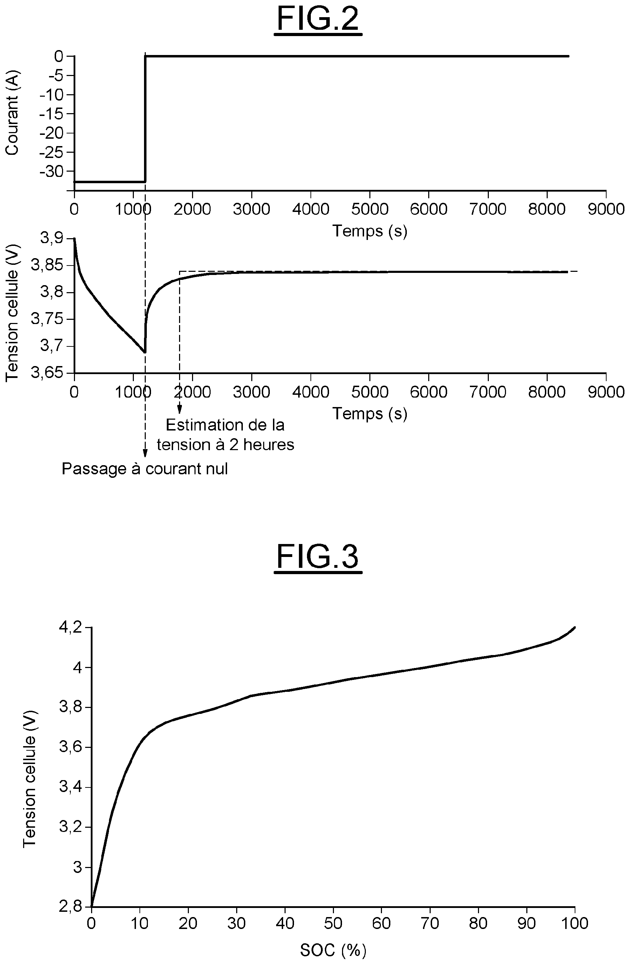

Ce phénomène est illustré sur la figure 2 pour une cellule d'un des modules, par exemple la cellule 21 du module 2.

La figure 2 montre deux repères comprenant chacun un axe horizontal représentant le temps en seconde et un axe vertical représentant respectivement le courant en Ampères traversant la cellule et la tension en Volts aux bornes de la cellule. Les deux courbes illustrées représentent respectivement l'évolution du courant traversant la cellule et l'évolution de la tension aux bornes de la cellule, en fonction du temps écoulé depuis la déconnexion du module.

L'instant de déconnexion du module comprenant la cellule est indiqué par le passage à un courant nul. La valeur de la tension de la cellule au moment de ce passage est très différente de la valeur de la tension à vide illustrée sur la figure 2 par la tension vers laquelle converge la tension aux bornes de la cellule. Cela est dû à la durée de relaxation de la cellule.

Selon un premier mode de réalisation, il est possible de déterminer la valeur de la tension à vide de la cellule par une mesure de la tension aux bornes de cette cellule après une durée suffisante suivant la déconnexion du module, par exemple 2 heures comme illustré sur la figure 2. La valeur obtenue n'est cependant qu'une approximation de la tension à vide et nécessite d'attendre deux heures à partir de la déconnexion. Cela n'est pas avantageux car un module déconnecté est un module qui ne peut pas être utilisé par exemple pour la propulsion du véhicule.

Selon un autre mode de réalisation, il est proposé d'utiliser une première méthode d'estimation de la tension à vide.

Pour cette méthode, la valeur de la tension à vide est calculée à l'aide de la formule :

$$V_{\infty} = V_0 + \eta\left(V_{10} - V_0\right)$$

dans laquelle $V_{\infty}$ est la tension à vide à estimer, $V_0$ est la tension aux bornes de la cellule au moment de la déconnexion du module comprenant cette cellule, $V_{10}$ est la tension aux bornes de la cellule un court instant après la déconnexion du module comprenant cette cellule (par exemple 10 secondes) et $\eta$ est un coefficient qui dépend de la température, du niveau de tension $V_{10}$, du régime de sollicitations préalable à l'arrêt (charge ou décharge) et de l'usure de la cellule. Il est par exemple déterminé à l'aide de tables obtenues par des essais de caractérisation.

Par exemple, on peut caractériser le coefficient $\eta$ pour 4 à 5 températures dans la plage de fonctionnement, en charge et en décharge, pour une dizaine de valeurs différentes de niveaux de tension $V_{10}$, et à deux niveaux d'usure de la cellule. Cette méthode a l'avantage de pouvoir être utilisée pour des intervalles de temps courts, permettant une disponibilité plus importante du module qui comprend les cellules dont la tension à vide est estimée. Cette méthode se base sur une connaissance a priori de la cellule, et ne permet donc pas toujours de s'adapter aux changements.

Selon encore un autre mode de réalisation, il est proposé d'utiliser une deuxième méthode d'estimation de la tension à vide.

Cette méthode consiste à estimer la loi de chute de polarisation ou loi de relaxation de la cellule à partir des mesures de tension réalisés sur un temps prédéfini (par exemple : 5 minutes) puis à déterminer vers quelle tension d'équilibre la loi estimée va converger.

En particulier, la loi de relaxation de la tension (notamment décrite dans le livre « Battery Management Systems Accurate State-of-Charge Indication for Battery-Powered Applications » de Valer Pop, Henk Jan Bergveld, Dmitry Danilov, Paul P.L. Regtien et Peter H.L. Notten) est définie selon la formule:

$$V(t) = V_{\infty} - \Gamma \frac{\gamma}{t^{\alpha} \log^{\delta}(t)} e^{\frac{\varepsilon_t}{2}},$$

avec $V(t)$ la tension de la cellule pour chaque instant $t$ de la phase de relaxation, $V_{\infty}$ la tension à vide à estimer, et $\Gamma$ un paramètre du modèle qui vaut 1 si la polarisation est négative et -1 si la polarisation est dans un sens positif, $\varepsilon_t$ l'erreur du modèle.

Selon cette méthode, on considère que dès que le courant passe à zéro (après une charge ou après une décharge), la polarisation suit cette loi. Il reste donc à définir un algorithme pour estimer les paramètres $\alpha$, $\delta$, $\gamma$ et $V_{\infty}$ de

cette formule.

Un exemple d'algorithme pour estimer ces paramètres est défini ci-dessous :

- étape 1 : plusieurs solutions candidates $V_\infty$ sont sélectionnées
- étape 2 : on résout le problème de régression linéaire suivant pour l'ensemble de données $V(t)$ observées à partir du passage à zéro du courant (sur un intervalle de 5 min, $0 \leq t \leq 5min$, par exemple) et pour chacune des solutions candidates $V_\infty$

$$\beta(V_\infty) = pinv(X).y(V_\infty)$$

où

$$\beta(V_\infty) = \begin{bmatrix} 2\log(\gamma) \\ -2\alpha \\ -2\delta \end{bmatrix}, \quad X = \begin{bmatrix} 1 & \log(t_1) & \log\log(t_1) \\ \vdots & \vdots & \vdots \\ 1 & \log(t_N) & \log\log(t_N) \end{bmatrix}, \quad y = \begin{bmatrix} 2.\log(V_\infty - V_{t_1}) \\ \vdots \\ 2.\log(V_\infty - V_{t_N}) \end{bmatrix}$$

et pinv(X) est la matrice pseudo-inverse de la matrice X.

- étape 3 : on détermine l'erreur du modèle pour chacune des solutions candidates $V_\infty$ selon

$$\hat{V}(V_\infty) = \begin{bmatrix} \hat{V}_{t_1} \\ \vdots \\ \hat{V}_{t_N} \end{bmatrix} = \begin{bmatrix} V_\infty - e^{\frac{X_{t_1}.\beta(V_\infty)}{2}} \\ \vdots \\ V_\infty - e^{\frac{X_{t_N}.\beta(V_\infty)}{2}} \end{bmatrix}, \text{ et } \varepsilon(V_\infty) = \left\| \hat{V}(V_\infty) - V \right\|^2$$

- étape 4 : on choisit la solution candidate $V_\infty$ qui minimise l'erreur $\varepsilon(V_\infty)$.

L'intérêt de cet algorithme est qu'il n'est pas nécessaire de connaître a priori les valeurs des termes $\alpha$, $\delta$, $\gamma$ et $V_\infty$. Au contraire, aucune connaissance a priori de la cellule n'est nécessaire. Cette méthode peut donc s'adapter aux changements. Elle est robuste, dans un contexte où les caractéristiques de la cellule pourraient évoluer du fait du vieillissement de la cellule.

Quel que soit le mode de réalisation, le bloc 46 effectue ensuite une détermination de l'état de charge (SOC, State Of Charge selon un terme anglo-saxon bien connu de l'homme du métier) de chacune des cellules du module déconnecté à partir des tensions à vide estimées (OCV) de chacune des cellules du module déconnecté.

Cette détermination est illustrée selon la figure 3. La figure 3 comprend un repère avec un axe horizontal représentant l'état de charge (SOC) en pourcentage et un axe vertical représentant la tension à vide de la cellule en volts. La courbe illustrée représente la valeur de l'état de charge en fonction de la tension à vide. Il est alors possible de déterminer avec cette courbe l'état de charge en fonction d'une tension à vide estimée.

La courbe illustrée est un exemple. Elle dépend en effet notamment de la composition chimique de la cellule et de la température. Cette courbe est, par exemple, déterminée de manière empirique au cours d'une caractérisation des cellules dans différentes gammes de température.

Le bloc de contrôle et de calcul 46 peut, selon un mode de réalisation, stocker pour chacune des cellules et plusieurs gammes de température, ces courbes qui lui permettent de déterminer l'état de charge de chacune des cellules à partir de la tension à vide (OCV).

En parallèle du traitement décrit ci-avant pour le module déconnecté, le bloc de contrôle et de calcul 46 recueille également la mesure du courant série réalisée par le capteur 45.

Le bloc 46 effectue alors à partir du courant série, une détermination de l'état de charge de chacune des cellules des modules connectés. Cette détermination comprend une intégration du courant série.

A titre d'exemple de réalisation, on peut utiliser la formule itérative ci-dessous :

$$\forall i \in \|1,6\|, \quad SoC_{b,i}(k) = SoC_{b,i}(k-1) + \frac{I_c(k) \cdot T_e}{Q_{\max b,i}}$$

dans laquelle b correspond à un numéro de bloc connecté, i correspond à un numéro de cellule du bloc connecté b, k correspond à un pas d'échantillonnage, $I_c(k)$ est le courant série mesuré par le capteur 45 au pas d'échantillonnage k, $T_e$ est la période d'échantillonnage du signal de courant correspondant également à la durée entre deux pas d'échantillonnage, $SoC_{b,i}(k)$ correspond à l'état de charge de la cellule i du module connecté b au pas d'échantillonnage k et $SoC_{b,i}(k-1)$ correspond à l'état de charge de la cellule i du module connecté b au pas d'échantillonnage k-1 et $Q_{\max b,i}$ est la charge maximale de la cellule i du module connecté numéro b.

Par ailleurs, dans le cas où le module b comportant la cellule i comprend un bloc d'équilibrage (5, 6, 7, 8) il est avantageux d'ajouter au courant série $I_c(k)$ le courant délivré par le bloc d'équilibrage du module b pour calculer l'état de charge de ladite cellule selon la formule ci dessus.

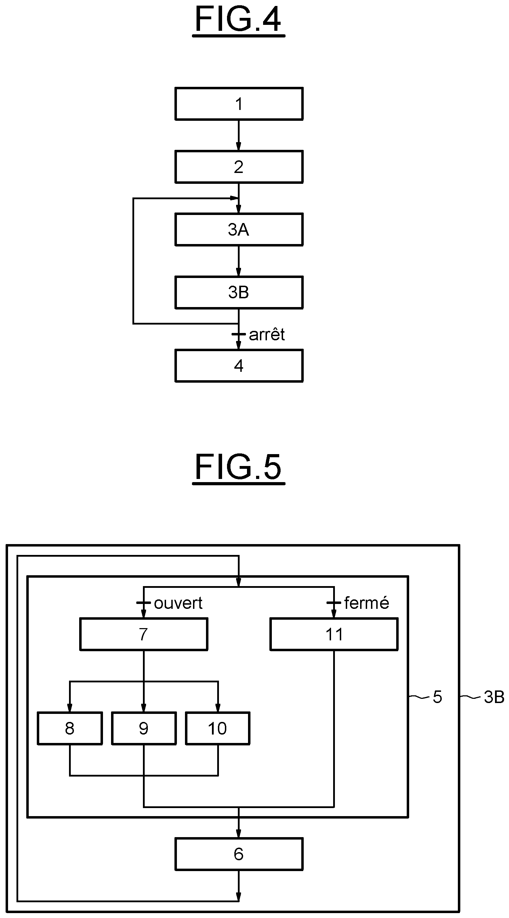

La figure 4 illustre un mode de mise en oeuvre d'un procédé de détermination de l'état de charge d'une batterie selon l'invention. Ce procédé est réalisé par le bloc de contrôle et de calcul 46. Il comprend 4 étapes.

Au cours d'une première étape d'initialisation (étape 1), il est déterminé l'état de la charge initial de toutes les cellules des modules de la batterie. En écriture mathématique, cela correspond à la détermination des valeurs $SoC_{b,i}(1)$ avec $1 \le b \le 4$ et $1 \le i \le 6$, le terme $SoC_{b,i}(1)$ correspondant à l'état de charge initial (d'où le chiffre 1 entre parenthèse) pour la cellule numéro i du module numéro b.

L'étape 1 comprend les sous étapes suivantes :

- On calcule la durée d'arrêt $T_{repos}$ pendant lequel le système est resté à l'arrêt ;
- On compare la durée d'arrêt $T_{repos}$ avec une valeur définie $T_{repos\_min}$ ;
- Si le repos a été suffisamment long pour que la relaxation ait eu lieu, c'est-à-dire si la durée d'arrêt est supérieure à la valeur définie ($T_{repos} \ge T_{repos\_min}$), on considère que la tension aux bornes de la cellule correspond à la tension à vide.

Puis, on détermine l'état de charge initial de chaque cellule à l'aide d'une courbe empirique telle que celle illustrée à la figure 3 représentant la relation unique entre la tension à vide et l'état de charge, pour une température donnée. C'est à dire en termes mathématiques :

$$\forall b \in \|1,4\|, \quad \forall i \in \|1,6\|, \quad SoC_{b,i}(1) = f\left(OCV_{b,i}(1), temperature_{b,i}(1)\right)$$

dans lequel $SoC_{b,i}(1)$ correspond à l'état de charge initial pour la cellule numéro i du module numéro b, $OCV_{b,i}(1)$ correspond à la tension à vide initiale (d'où le chiffre 1 entre parenthèse) pour la cellule numéro i du module numéro b, $temperature_{b,i}(1)$ correspond à la température de la cellule numéro i du module numéro b, et $f()$ est une fonction dont la courbe est illustrée sur la figure 3 et qui permet de déterminer l'état de charge en fonction de la tension à vide.

- Si le repos n'a pas été suffisamment long ($T_{repos} < T_{repos\_min}$), l'état de charge initial de chaque cellule est déterminé par recopie de la dernière valeur estimée, mémorisée lors d'une étape d'arrêt (décrite ci-après). C'est à dire en termes mathématiques :

$$\forall b \in \|1,4\|, \quad \forall i \in \|1,6\|, \quad SoC_{b,i}(1) = SoC_{b,i\_memorisée}$$

dans lequel $SoC_{b,i}(1)$ correspond à l'état de charge initial (d'où le chiffre 1 entre parenthèse) pour la cellule numéro i du module numéro b et $SoC_{b,i\_memorisée}$ correspond à la dernière valeur estimée, mémorisée lors de l'étape d'arrêt, de l'état de charge de la cellule numéro i du module numéro b.

Le procédé comprend également une deuxième étape (étape 2 sur la figure 4) de détermination de l'état de charge initial de la batterie à partir des états de charge initiaux de chacune des cellules de la batterie. Par exemple, la formule ci-dessous peut être utilisée:

$$SoC_{pack}(1) = \min_{1 \le b \le 4, 1 \le i \le 6} \left(SoC_{b,i}(1)\right)$$

EP 2 850 445 B1

dans laquelle $SoC_{pack}(1)$ correspond à l'état de charge initial de la batterie et la fonction $\min_{1 \leq b \leq 4, 1 \leq i \leq 6} (\ )$ permet de déterminer l'état de charge initial minimal de l'ensemble des cellules de la batterie.

Le procédé se poursuit par une étape 3A de déconnexion sélective d'un des modules. Cette étape 3A est réalisée à l'aide des moyens de commutation et du bloc 46 illustrés sur la figure 1. Cette étape 3A est réalisée successivement pour déconnecter chacun des b modules, pendant des durées paramétrables (par exemple 5 secondes).

Le procédé comprend en outre une étape 3B de détermination de l'état de charge de chacune des cellules au cours du temps. Pour chacun des b modules, la façon d'estimer les états de charge des cellules le composant dépend de l'état des moyens de commutation associés au module. Un exemple de réalisation de cette étape 3B est décrit ultérieurement (figure 5).

Le procédé peut comprendre une étape d'arrêt 4. Cette étape est, par exemple, déclenchée par un arrêt du véhicule ou tout événement justifiant l'arrêt du bloc 46.

L'étape 4 comprend l'écriture en mémoire des derniers états de charge déterminés de chacune des cellules. C'est à dire en termes mathématiques :

$$\forall b \in \|1,4\|, \quad \forall i \in \|1,6\|, \quad SoC_{b,i\_memorisée} = SoC_{b,i}(k)$$

dans lequel $SoC_{b,i}(k)$ correspond à l'état de charge au dernier pas d'échantillonnage k (d'où le chiffre k entre parenthèse) pour la cellule numéro i du module numéro b et $SoC_{b,i\_memorisée}$ correspond à la valeur d'état de charge qui est mémorisée lors de l'étape d'arrêt pour la cellule numéro i du module numéro b.

La figure 5 illustre à titre d'exemple un mode de mise en oeuvre de l'étape 3B.

Cette étape comprend une étape 5 et une étape 6 qui sont réalisées de manière successive pour chacun des pas d'échantillonnage.

L'étape 5 est en outre répétée pour chacun des b modules de la batterie ($1 \leq b \leq 4$).

L'étape 5 se subdivise en deux branches, chacune des branches étant réalisée en fonction de l'état (connecté ou déconnecté) du module b considéré.

La première branche comprend les étapes 7, 8, 9, 10. Elle correspond au cas d'un module déconnecté, c'est-à-dire un module dont le commutateur série en entrée est ouvert.

L'étape 7 est une étape de détermination de la durée de déconnexion du module.

L'étape 7 est par exemple réalisée à l'aide d'une incrémentation de la durée d'ouverture $T_{CS}$ du commutateur série du module comprenant la cellule considérée.

Puis, la première branche se poursuit suivant les étapes 8, 9 et 10 qui sont réalisées selon la durée d'ouverture $T_{CS}$.

Si la durée d'ouverture n'a pas été suffisamment longue ($T_{CS} < T_{ouverture\_min}$), l'étape 8 est réalisée. Selon cette étape, l'état de charge de chaque cellule du module b considéré est maintenu à la valeur du pas de temps précédent. En effet, il n'y a pas de courant qui circule dans la cellule. En termes mathématiques :

$$\forall i \in \|1,6\|, \quad SoC_{b,i}(k) = SoC_{b,i}(k-1)$$

dans laquelle $SoC_{b,i}(k)$ correspond à l'état de charge de la cellule i du module déconnecté b au pas d'échantillonnage k et $SoC_{b,i}(k-1)$ correspond à l'état de charge de la cellule i du module déconnecté b au pas d'échantillonnage k-1.

Si l'intervalle de temps d'ouverture a été suffisamment long ($T_{CS} = T_{ouverture\_min}$), l'étape 9 est réalisée.

Selon l'étape 9, la tension de relaxation de chaque cellule du module b considéré est estimée à l'aide, par exemple, d'une des méthodes mentionnées ci avant (première méthode utilisant la tension aux bornes de la cellule un court instant après la déconnexion du module ou deuxième méthode utilisant la loi de chute de polarisation). Il est ainsi possible d'obtenir $V_{\infty b,i}(k)$, $\forall i \in \|1,6\|$, dans laquelle $V_{\infty b,i}(k)$ est la tension à vide pour le pas d'échantillonnage k de la cellule i appartenant au module b considéré.

L'état de charge de chaque cellule du module est alors calculé directement à partir de la relation :

$$\forall i \in \|1,6\|, \quad SoC_{b,i}(k) = f\left(V_{\infty b,i}(k), temperature_{b,i}(k)\right),$$

dans laquelle $f(\ )$ est une fonction dont la courbe est par exemple illustrée sur la figure 3 et qui permet de déterminer l'état de charge en fonction de la tension à vide, $SoC_{b,i}(k)$ correspond à l'état de charge au pas d'échantillonnage k (d'où le chiffre k entre parenthèse) pour la cellule i du module déconnecté b, et $V_{\infty b,i}(k)$ est la tension à vide pour le pas d'échantillonnage k de la cellule i appartenant au module déconnecté b.

Cette étape 9 correspond donc, pour chaque cellule du module b considéré, à une estimation de la tension à vide de la cellule à partir de la tension aux bornes de la cellule et une détermination de l'état de charge à partir de ladite tension à vide estimée. Elle est réalisée si la durée de déconnexion est égale à une certaine durée.

Si la durée d'ouverture est supérieure à la durée minimale ($T_{CS} > T_{ouverture\_min}$), l'étape 10 est réalisée. Selon cette étape, l'état de charge de chaque cellule est maintenu à la valeur du pas précédent. En termes mathématiques :

$$\forall i \in \|1,6\|, \quad SoC_{b,i}(k) = SoC_{b,i}(k-1) \qquad dans \qquad laquelle \qquad SoC_{b,i}(k)$$

dans laquelle $SoC_{b,i}(k)$ correspond à l'état de charge de la cellule i du module déconnecté b au pas d'échantillonnage k et $SoC_{b,i}(k-1)$ correspond à l'état de charge de la cellule i du module déconnecté b au pas d'échantillonnage k-1.

Ainsi, l'étape 8 revient à conserver la valeur du SOC estimé à l'instant k-1 $SoC_{b,i}(k-1)$ (obtenue par intégration du courant) tant que la durée de déconnexion n'a pas été suffisante.

L'étape 10 consiste à conserver la valeur du SOC obtenue $SoC_{b,i}(k-1)$ par estimation de la tension après relaxation, tant que le module n'est pas reconnecté.

La deuxième branche comprend l'étape 11 qui correspond au cas d'un module connecté, c'est-à-dire un module dont le commutateur série en entrée est fermé.

L'étape 11 est une étape de détermination de l'état de charge de chacune des cellules du module b considéré. Ces cellules sont traversées par un même courant série déterminé par le capteur 45. L'état de charge de chacune de ces cellules est calculé par intégration de la mesure de courant série :

$$\forall i \in \|1,6\|, \quad SoC_{b,i}(k) = SoC_{b,i}(k-1) + \frac{I_c(k) \cdot T_e}{Q_{\max b,i}}$$

dans laquelle $T_e$ est la période d'échantillonnage du signal de courant correspondant également à la durée entre deux pas d'échantillonnage, $I_c(k)$ est le courant série mesuré par le capteur 45 au pas d'échantillonnage k, $SoC_{b,i}(k)$ correspond à l'état de charge de la cellule i du module connecté b au pas d'échantillonnage k et $SoC_{b,i}(k-1)$ correspond à l'état de charge de la cellule i du module connecté b au pas d'échantillonnage k-1 et $Q_{maxb,i}$ est la charge maximale de la cellule i du module connecté b. Dans le cas où le module b considéré comprend un bloc d'équilibrage, il est avantageux d'ajouter au courant série $I_c(k)$ le courant délivré par le bloc d'équilibrage à chacune des cellules composant le module b, pour calculer l'état de charge de ces cellules selon la formule ci dessus.

L'étape 6 est une étape de détermination de l'état de charge de la batterie au pas d'échantillonnage k à partir des états de charge de toutes les cellules de la batterie au pas d'échantillonnage k. Un exemple de formule utilisable pour l'étape 6 est : $SoC_{pack}(k) = \min_{1 \le b \le 4, 1 \le i \le 6} \left( SoC_{b,i}(k) \right)$, dans laquelle $SoC_{pack}(k)$ correspond à l'état de charge au pas d'échantillonnage k de la batterie et la fonction $\min_{1 \le b \le 4, 1 \le i \le 6}()$ permet de déterminer l'état de charge minimal de l'ensemble des cellules de la batterie au pas d'échantillonnage k.

Le système et le procédé correspondant décrits selon l'invention permettent avec un dispositif simple d'obtenir une estimation précise de l'état de charge d'une batterie comprenant au moins deux modules, chacun des deux modules ayant au moins une cellule. Cette précision est obtenue grâce à une détermination de l'état de charge à l'aide d'une détermination de la tension à vide, qui est par exemple réalisée régulièrement sur chacun des modules. Cette détermination de la tension à vide peut être réalisée sans interruption de la batterie (les autres modules restant connectés en série) et peut donc être relativement fréquente.

## Revendications

1. Système d'estimation de l'état de charge d'une batterie comportant au moins deux modules (1, 2, 3, 4) équipés chacun d'au moins une cellule (13-18, 19-24, 25-30, 31-36), ledit système comprenant un capteur (45) du courant série traversant l'ensemble des cellules des modules connectés en série, **caractérisé en ce qu'**il comprend en outre :

    - des moyens de commutation (37-44) capable de sélectivement déconnecter l'un des modules, les autres modules restant connectés en série; et
    - un moyen de calcul (46) configuré pour calculer l'état de charge des cellules traversées par ledit courant série à partir de l'intégration du courant série et pour calculer l'état de charge de chacune des cellules du module déconnecté à partir de leur tension à vide.

2. Système d'estimation selon la revendication 1, comprenant en outre des capteurs de tension (9-12) aux bornes de chacune des cellules du module déconnecté, et dont le moyen de calcul est configuré pour calculer la tension à vide de chacune des cellules du module déconnecté à partir de la tension aux bornes de la cellule.

3. Système d'estimation selon la revendication 2, dans lequel le moyen de calcul (46) comprend des moyens d'estimation configurés pour estimer, pour chacune des cellules du module déconnecté, la tension à vide à partir de la tension aux bornes de la cellule, lesdits moyens d'estimation comprenant :

   - des moyens d'enregistrement pour conserver en mémoire la valeur d'un coefficient obtenu par des essais de caractérisation de la cellule; et
   - des moyens d'addition configurés pour additionner la tension aux bornes de la cellule au moment de la déconnexion du module avec le résultat de la multiplication entre ledit coefficient et la différence entre la tension aux bornes de la cellule un court instant après la déconnexion du module et la tension aux bornes de la cellule au moment de la déconnexion du module.

4. Système d'estimation selon la revendication 2, dans lequel le moyen de calcul comprend des moyens d'estimation configurés pour estimer, pour chacune des cellules du module déconnecté, la tension à vide à partir des tensions aux bornes de la cellule, lesdits moyens d'estimation comprenant :

   - des moyens de détermination d'une loi régissant la chute de polarisation de la cellule, à partir l'évolution de la tension aux bornes de la cellule pendant une certaine durée à compter de la déconnexion du module ; et
   - des moyens de calcul de la valeur vers laquelle ladite loi converge.

5. Système selon l'une des revendications précédentes, dans lequel les moyens de commutation sont contrôlés par un moyen de contrôle (46), les moyens de commutation étant contrôlés par le moyen de contrôle de sorte que chacun des modules est déconnecté régulièrement.

6. Système selon l'une des revendications précédentes, dans lequel les moyens de commutation comprennent pour chacun des modules de la batterie, un commutateur série branché (41-44) à l'entrée du module correspondant (9-12) et des commutateurs parallèle (37-40) branchés en parallèle de chacun des commutateurs série et du module correspondant(41, 9, 42, 10, 43, 11, 44, 12).

7. Système selon l'une des revendications précédentes, dans lequel au moins un module comprend un moyen d'équilibrage (5-8) configuré pour ajouter un courant d'équilibrage au courant traversant les cellules dudit module.

8. Procédé d'estimation de l'état de charge d'une batterie comportant au moins deux modules équipés chacun d'au moins une cellule **caractérisé en ce que** le procédé comprend :

   - une étape de déconnexion sélective (3A) d'un module, les autres modules restant connectés en série et leurs cellules étant traversées par un courant série ;
   - des étapes de détermination (3B) réalisées successivement comprenant, pour chacune des cellules de la batterie :

      - une addition de l'intégration (11) du courant série au dernier état de charge déterminé de la cellule, si la cellule appartient à un module connecté en série; ou
      - une étape de détermination (7-10) de l'état de charge de la cellule à partir de la tension à vide de la cellule, si la cellule appartient à un module déconnecté.

9. Procédé selon la revendication 8, dans lequel l'étape de détermination (7-10) de l'état de charge à partir de la tension à vide de la cellule, si la cellule appartient à un module déconnecté, comprend :

   - une détermination (7) de la durée de déconnexion ;
   - une estimation (9) de la tension à vide de la cellule à partir de la tension aux bornes de la cellule et une détermination de l'état de charge à partir de ladite tension à vide estimée, si la durée de déconnexion est égale à une certaine durée ; ou

- une recopie (8, 10) du dernier état de charge déterminé de la cellule, si la durée de déconnexion est supérieure (10) ou inférieure (8) à ladite certaine durée.

10. Procédé selon la revendication 9, comprenant en outre une étape d'arrêt (4) qui comprend une mémorisation des dernières valeurs d'état de charge déterminées pour chacune des cellules.

**Patentansprüche**

1. System zur Schätzung des Ladezustands einer Batterie, welche wenigstens zwei Module (1, 2, 3, 4) aufweist, die jeweils mit wenigstens einer Zelle (13-18, 19-24, 25-30, 31-36) ausgestattet sind, wobei das System einen Sensor (45) für den Reihenstrom umfasst, der durch die Anordnung der Zellen der in Reihe geschalteten Module fließt, **dadurch gekennzeichnet, dass** es außerdem umfasst:

- Umschaltmittel (37-44), die geeignet sind, selektiv eines der Module abzuklemmen, während die anderen Module in Reihe geschaltet bleiben; und
- ein Berechnungsmittel (46), das dafür ausgelegt ist, den Ladezustand der von dem Reihenstrom durchflossenen Zellen aus der Integration des Reihenstroms zu berechnen und den Ladezustand jeder der Zellen des abgeklemmten Moduls aus ihrer Leerlaufspannung zu berechnen.

2. System zur Schätzung nach Anspruch 1, welches außerdem Spannungssensoren (9-12) an den Klemmen jeder der Zellen des abgeklemmten Moduls umfasst und dessen Berechnungsmittel dafür ausgelegt ist, die Leerlaufspannung jeder der Zellen des abgeklemmten Moduls aus der Spannung an den Klemmen der Zelle zu berechnen.

3. System zur Schätzung nach Anspruch 2, wobei das Berechnungsmittel (46) Schätzmittel umfasst, die dafür ausgelegt sind, für jede der Zellen des abgeklemmten Moduls die Leerlaufspannung anhand der Spannung an den Klemmen der Zelle zu schätzen, wobei die Schätzmittel umfassen:

- Aufzeichnungsmittel zum Aufbewahren des Wertes eines Koeffizienten, der durch Versuche zur Charakterisierung der Zelle erhalten wurde, in einem Speicher; und
- Additionsmittel, die dafür ausgelegt sind, die Spannung an den Klemmen der Zelle zum Zeitpunkt des Abklemmens des Moduls zum Ergebnis der Multiplikation des besagten Koeffizienten mit der Differenz zwischen der Spannung an den Klemmen der Zelle eine kurze Zeit nach dem Abklemmen des Moduls und der Spannung an den Klemmen der Zelle zum Zeitpunkt des Abklemmens des Moduls zu addieren.

4. System zur Schätzung nach Anspruch 2, wobei das Berechnungsmittel Schätzmittel umfasst, die dafür ausgelegt sind, für jede der Zellen des abgeklemmten Moduls die Leerlaufspannung anhand der Spannungen an den Klemmen der Zelle zu schätzen, wobei die Schätzmittel umfassen:

- Mittel zur Bestimmung einer Funktion, welche den Abfall der Polarisation der Zelle beschreibt, aus der Änderung der Spannung an den Klemmen der Zelle während einer gewissen Dauer ab dem Abklemmen des Moduls; und
- Mittel zur Berechnung des Wertes, gegen den diese Funktion konvergiert.

5. System nach einem der vorhergehenden Ansprüche, wobei die Umschaltmittel von einem Steuerungsmittel (46) gesteuert werden, wobei die Umschaltmittel von dem Steuerungsmittel derart gesteuert werden, dass jedes der Module regelmäßig abgeklemmt wird.

6. System nach einem der vorhergehenden Ansprüche, wobei die Umschaltmittel für jedes der Module der Batterie einen Reihen-Umschalter (41-44), der an den Eingang des entsprechenden Moduls (9-12) angeschlossen ist, und Parallel-Umschalter (37-40), die jeweils zu einem der Reihen-Umschalter und dem entsprechenden Modul (41, 9, 42, 10, 43, 11, 44, 12) parallel geschaltet sind, umfassen.

7. System nach einem der vorhergehenden Ansprüche, wobei wenigstens ein Modul ein Ausgleichsmittel (5-8) umfasst, das dafür ausgelegt ist, zu dem Strom, der durch die Zellen des Moduls fließt, einen Ausgleichsstrom hinzuzufügen.

8. Verfahren zur Schätzung des Ladezustands einer Batterie, welche wenigstens zwei Module aufweist, die jeweils mit wenigstens einer Zelle ausgestattet sind, **dadurch gekennzeichnet, dass** das Verfahren umfasst:

- einen Schritt des selektiven Abklemmens (3A) eines Moduls, während die anderen Module in Reihe geschaltet bleiben und ihre Zellen von einem Reihenstrom durchflossen werden;
- Bestimmungsschritte (3B), die nacheinander ausgeführt werden und für jede der Zellen der Batterie umfassen:

- eine Addition der Integration (11) des Reihenstroms zum letzten bestimmten Ladezustand der Zelle, falls die Zelle zu einem in Reihe geschalteten Modul gehört; oder
- einen Schritt der Bestimmung (7-10) des Ladezustands der Zelle aus der Leerlaufspannung der Zelle, falls die Zelle zu einem abgeklemmten Modul gehört.

9. Verfahren nach Anspruch 8, wobei der Schritt der Bestimmung (7-10) des Ladezustands aus der Leerlaufspannung der Zelle, falls die Zelle zu einem abgeklemmten Modul gehört, umfasst:

- eine Bestimmung (7) der Dauer des Abklemmens;
- eine Schätzung (9) der Leerlaufspannung der Zelle anhand der Spannung an den Klemmen der Zelle und eine Bestimmung des Ladezustands aus der geschätzten Leerlaufspannung, falls die Dauer des Abklemmens gleich einer gewissen Dauer ist; oder
- ein Übernehmen (8, 10) des letzten bestimmten Ladezustands der Zelle, falls die Dauer des Abklemmens länger (10) oder kürzer (8) als die gewisse Dauer ist.

10. Verfahren nach Anspruch 9, welches außerdem einen Anhalteschritt (4) umfasst, welcher eine Speicherung der letzten bestimmten Werte des Ladezustands für jede der Zellen umfasst.

## Claims

1. System for estimating the state of charge of a battery comprising at least two modules (1, 2, 3, 4) each provided with at least one cell (13-18, 19-24, 25-30, 31-36), said system including a sensor (45) of the series current flowing through all the cells of the modules connected in series, **characterized in that** it further includes:

- switching means (37-44) capable of selectively disconnecting one of the modules, the other modules remaining connected in series; and
- a calculation means (46) configured for calculating the state of charge of the cells through which said series current flows from the integration of the series current and for calculating the state of charge of each of the cells of the disconnected module from the open circuit voltage thereof.

2. Estimating system according to claim 1, further including voltage sensors (9-12) at the terminals of each of the cells of the disconnected module, and whereof the calculation means is configured for calculating the open circuit voltage of each of the cells of the disconnected module from the voltage at the cell terminals.

3. Estimating system according to Claim 2, **characterized in that** the calculation means (46) includes estimating means configured for estimating, for each of the cells of the disconnected module, the open circuit voltage from the voltage at the cell terminals, said estimating means including:

- recording means for storing in memory the value of a coefficient obtained by cell characterization tests; and
- adding means configured for adding the voltage at the cell terminals at the time that the module is disconnected with the result of the multiplication between said coefficient and the difference between the voltage at the cell terminals a short time after the module is disconnected and the voltage at the cell terminals at the time that the module is disconnected.

4. Estimating system according to Claim 2, **characterized in that** the calculation means includes estimating means configured for estimating, for each of the cells of the disconnected module, the open circuit voltage from the voltage at the cell terminals, said estimating means including:

- means for determining a law governing the drop in polarization of the cell, from the evolution in voltage at the cell terminals for a certain duration counting from the disconnection of the module; and
- means for calculating the value toward which said law converges.

5. System according to one of the preceding claims, **characterized in that** the switching means are controlled by a control means (46), the switching means being controlled by the control means so that each of the modules is regularly disconnected.

6. System according to one of the preceding claims, **characterized in that** the switching means include for each of the battery modules a series switch connected (41-44) to the input of the corresponding module (9-12) and parallel switches (37-40) connected in parallel with each of the series switches and the corresponding module (41, 9, 42, 10, 43, 11, 44, 12) .

7. System according to one of the preceding claims, **characterized in that** at least one module includes a balancing means (5-8) configured for adding a balancing current to the current flowing through the cells of said module.

8. Method of estimating the state of charge of a battery comprising at least two modules, each fitted with at least one cell, **characterized in that** the method includes:

   - a step of selective disconnection (3A) of a module, the other modules remaining connected in series and a series current flowing through the cells of same;
   - determining steps (3B) performed successively including, for each of the battery cells:

      - an addition of the integration (11) of the series current at the last determined state of charge of the cell, if the cell belongs to a module connected in series; or
      - a step for determining (7-10) the state of charge of the cell from the open circuit voltage of the cell, if the cell belongs to a disconnected module.

9. Method according to Claim 8, **characterized in that** the step for determining (7-10) the state of charge of the cell from the open circuit voltage of the cell, if the cell belongs to a disconnected module, includes:

   - a determination (7) of the duration of disconnection;
   - an estimation (9) of the open circuit voltage of the cell from the voltage at the cell terminals and a determination of the state of charge from said estimated open circuit voltage, if the duration of disconnection is equal to a certain duration; or
   - copying (8, 10) the last determined state of charge of the cell, if the duration of disconnection is greater than (10) or less than (8) said certain duration.

10. Method according to Claim 9, further including a stopping step (4) which includes storage of the last state of charge values determined for each of the cells.

## FIG.1

# FIG.2

Passage à courant nul

Estimation de la
tension à 2 heures

# FIG.3

# FIG.4

# FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• EP 1384086 A

**Littérature non-brevet citée dans la description**

• **M. BRANDL.** *Batteries and Battery Management Systems for Electric Vehicles*

• **DE VALER POP ; HENK JAN BERGVELD ; DMITRY DANILOV ; PAUL P.L. REGTIEN ; PETER H.L. NOTTEN.** *Battery Management Systems Accurate State-of-Charge Indication for Battery-Powered Applications*